# EUROPÄISCHE PATENTSCHRIFT

(11) **EP 2 247 451 B1**
(45) Veröffentlichungstag und Bekanntmachung des Hinweises auf die Patenterteilung: **31.08.2011**
(21) Anmeldenummer: 08863400.1
(22) Anmeldetag: 14.11.2008
(51) Int. Cl.: B44C 1/00, B32B 38/14

(54) **VERFAHREN ZUM HERSTELLEN EINES DEKORIERTEN PROFILKÖRPERS**
METHOD FOR PRODUCING A DECORATED PROFILE BODY
PROCÉDÉ DE FABRICATION D'UN CORPS PROFILÉ DÉCORÉ

(30) Priorität: 20.12.2007 DE 102007062479; 23.02.2008 DE 102008010738
(43) Veröffentlichungstag der Anmeldung: 10.11.2010
(73) Patentinhaber: Rehau AG + Co, 95111 Rehau (DE)
(72) Erfinder: KÜHNBERGER, Sven, 95152 Selbitz (DE); HAGEN, Oliver, 95032 Hof (DE); EYHORN, Stefan, 70563 Stuttgart (DE)
(86) Internationale Anmeldenummer: PCT/EP2008/009666
(87) Internationale Veröffentlichungsnummer: WO 2009/080160

(56) Entgegenhaltungen:
- EP-A- 1 454 741
- EP-A- 1 858 244
- WO-A-2004/013713
- DE-A1- 19 823 195

## Beschreibung

Die vorliegende Erfindung betrifft ein Verfahren zum Herstellen eines dekorierten Profilkörpers, umfassend die Schritte: Bereitstellen eines Substrats; Auftragen eines Dekorgrundes; und Auftragen einer den Dekorgrund zumindest abschnittsweise bedeckenden Dekorveredelung im Digitaldruckverfahren, wobei der Dekorgrund und die Dekorveredelung zusammen ein Dekor des Profilkörpers bilden. Ein derartiges Verfahren ist aus der Druckschrift WO 2004/013713 bekannt.

Im Bereich der Möbelindustrie werden zum Dekorieren von Tischplatten und Küchenarbeitsplatten konventionelle Druckverfahren, wie z.B. Tiefdruckverfahren eingesetzt. Das charakteristische Erscheinungsbild dieses Dekors (nachfolgend: Referenzdekor) ändert sich bei Wechseln der Lichtart farblich. Der Farbeindruck des Dekors eines an der Platte angebrachten Profilkörpers (z.B. Kantenband) muss sich in gleicher Weise ändern wie das Referenzdekor, da sonst der so genannte Metamerie-Effekt auftritt. Der Begriff "Metamerie" ist in DIN 6172 definiert und bezeichnet sinngemäß einen Effekt, wonach zwei Proben, die unter einer Lichtart gleich aussehen, unter einer anderen Lichtart einen Farbabstand zeigen.

Die Dekorvorlagen bzw. Vorlagenplatten aus dem Bereich der Möbelindustrie weisen eine große Palette an Farbpigmenten auf und sind in der Regel mit wasserbasierter Tinte bedruckt, wobei als Dekorträger bzw. Substrat ein eingefärbtes, saugfähiges Papier verwendet wird. Die Pigmentauswahl für diese Drucktinte ist verfahrensbedingt kaum eingeschränkt. Dagegen erlaubt das Tintenstrahldruckverfahren verfahrensbedingt nur eine eingeschränkte Auswahl von Farbpigmenten. Um das Referenzdekor auch auf andere Substrate, insbesondere polymere Substrate, wie Wandanschlussprofile und Kantenbänder zu drucken, ist jedoch primär der Einsatz gleicher Pigmentarten und -größen die Grundvoraussetzung für einen metameriefreien Druckaufbau.

Bei der Bedruckung von Substraten mithilfe der digitalen Tintenstrahldrucktechnik (Inkjet) nach den Verfahren "Drop on Demand" und "Continuous Inkjet", sind die eingesetzten Farbsysteme meist für den jeweiligen Druckkopf entwickelt und speziell an den Bedruckstoff angepasst. Der Farbaufbau erfolgt in der Regel nach dem CMYK-Prinzip, d.h. durch Kombination der Farben Cyan, Magenta und Yellow und Schwarz (Key). Bei der digitalen Bedruckung mit Farbaufbau nach dem CMYK-Prinzip steht somit gegenüber den konventionellen Druckverfahren, wie z.B. dem Tiefdruckverfahren, nur eine eingeschränkte Farbauswahl zur Verfügung, die nicht hinreichend ist, um den Metamerie-Effekt zu vermeiden.

Der Erfindung liegt demnach die Aufgabe zugrunde, einen dekorierten Profilkörper bzw. ein Verfahren zu dessen Herstellung bereit zu stellen, wonach auch bei der digitalen Bedruckung des Profilkörpers der gesamte Farbraum der konventionellen Druckverfahren, wie z.B. des Tiefdruckverfahrens, erfassbar ist und somit ein Metamerie-Effekt zumindest weitgehend verhindert werden kann.

Zur Lösung der Aufgabe stellt die vorliegende Erfindung das Verfahren zum Herstellen eines dekorierten Profilkörpers nach Anspruch 1 bereit, umfassend die Schritte: Bereitstellen eines Substrats; Auftragen eines Dekorgrundes; und Auftragen einer den Dekorgrund zumindest abschnittsweise bedeckenden Dekorveredelung im Digitaldruckverfahren; wobei der Dekorgrund und die Dekorveredelung zusammen ein Dekor des Profilkörpers bilden; wobei der Dekorgrund einen Farbaufbau aus einem gegenüber der Dekorveredelung erweiterten Farbraum aufweist, wobei der Farbaufbau des Dekorgrundes derart ausgewählt ist, dass zwischen dem Dekor des Profilkörpers und einem dazu ähnlichen, vorzugsweise identischen, Referenzdekor im Wesentlichen kein Metamerie-Effekt auftritt. Digitaldruckverfahren meint digital angesteuerte Druckverfahren, wie z.B. Tintenstrahldruckverfahren, Tonerverfahren (z.B. mit Laser), Elektrofotographie, lonographie, Magnetographie, Thermographie oder dergleichen. Die Erfindung baut im Wesentlichen darauf auf, dass der Dekorgrund und die Dekorveredelung gemeinsam das sichtbare Dekor des Profilkörpers bilden. Die Dekorveredelung wird z.B. nach CYMK-Prinzip im Tintenstrahldruckverfahren aufgetragen und weist den beschränkten Farbraum auf.

Der Dekorgrund erweitert den beschränkten CYMK-Farbraum durch gezielte Farbmittelauswahl derart, dass auch bei der digitalen Bedruckung des Profilkörpers mit einem Farbaufbau nach dem CMYK-Prinzip der gesamte Farbraum der konventionellen Druckverfahren, wie z.B. des Tiefdruckverfahrens, erfassbar und darstellbar ist und somit ein Metamerie-Effekt im Wesentlichen verhindert werden kann. Hierdurch ist man in der Lage, beliebige Referenzdekore auch mithilfe eines Digitaldruckverfahrens nachzustellen, ohne dass sich ein signifikanter Metamerie-Effekt einstellt.

Im Rahmen der Erfindung liegt es insbesondere auch, dass die Dekorveredelung vor dem Dekorgrund auf das Substrat aufgebracht wird. Dies erlaubt eine Anwendung des erfindungsgemäßen Verfahrens auch auf durchsichtige, d.h. transparente oder transluzente Substrate, die rückseitig bedruckt werden, wie z.B. in der DE 1 964 911 U beschrieben.

Bevorzugte Ausführungen der vorliegenden Erfindung werden in den Unteransprüchen beansprucht.

Es kann sich als vorteilhaft erweisen, wenn der Dekorgrund zwei unterschiedlich eingefärbte Fondschichten aufweist. Diese unterschiedlich eingefärbten Fondschichten werden im Folgenden als Universal-Fondschicht und Individual-Fondschicht bezeichnet.

Die sogenannte Universal-Fondschicht wird auf das Substrat aufgetragen, um fertigungsbedingte Unregelmäßigkeiten (z.B. Farbnuancen etc.) des Substrats auszugleichen bzw. um das Substrat in farblicher Hinsicht zu neutralisieren, so dass das Dekor mit hoher Präzision und Farbgenauigkeit reproduziert werden kann. In diesem Zustand wird das Substrat zur Weiterverarbeitung auf Lager gehalten.

Die sogenannte Individual-Fondschicht wird vorzugsweise erst bei Kenntnis des konkreten Anwendungsfalls aufgetragen, und kann bereits einen Grundfarbton des zu erzielenden Dekors enthalten. Zusätzlich kann die Individual-Fondschicht bereits in einem dem Grundfarbton des Referenzdekors entsprechenden Farbton eingefärbt sein, wobei das Dekor des Profilkörpers vorzugsweise auf das Referenzdekor abgestimmt ist.

Die Individual-Fondschicht enthält vorzugsweise eine individuell gemischte Sonderfarbe, wobei der Farbaufbau der Individual-Fondschicht aus einem gegenüber der Dekorveredelung erweiterten Farbraum ausgewählt ist. Die Dekorveredelung weist z.B. einen aus dem CYMK-Farbraum ausgewählten Farbaufbau auf.

Durch diese Kombination aus Individual-Fond und Dekorveredelung kann der Farbraum des Dekors des Profilkörpers über den gegebenen Farbraum der reinen Skalenfarben erweitert werden. Die Feinabstimmung der Farbtöne der Individual-Fondschicht und der Dekorveredelung kann mittels geeigneter Software erfolgen. Die Individual-Fondschicht kann, muss aber nicht, Teil des sichtbaren Dekors des Profilkörpers sein. Ein nicht offen sichtbarer Teil hat jedoch trotzdem erheblichen Einfluss auf das Erscheinungsbild und die farbliche Wirkung des Dekors des Profilkörpers, da die Dekorveredelung in der Regel nicht vollständig deckend ist, aufgrund nicht deckender Pigmente. Dieser Effekt kann genutzt werden, um durch gezielte Pigmentauswahl und Mischung der Farbe die Individual-Fondschicht derart zu steuern, dass das Umschlagen der Farbe des Dekors des Profilkörpers bei Lichtartwechsel im Sinne des Referenzdekors erfolgt und somit Metamerie-Effekte vermieden werden können.

Es kann sich als nützlich erweisen, wenn als Dekorveredelung zumindest abschnittsweise eine transluzente oder transparente Substanz aufgetragen wird, z.B. durch Verwendung von nicht deckenden Pigmenten. Dadurch können optisch und ästhetisch besonders ansprechende Ergebnisse erzielt werden. Im Übrigen wird dadurch der Designspielraum erheblich erweitert, weil auch die unter der Dekorveredelung liegenden Schichten des Profilkörpers in das sichtbare Dekor einbezogen werden können und somit zum optischen und ästhetischen Gesamteindruck des Profilkörpers beitragen.

Es kann von Vorteil sein, wenn die Dekorveredelung strahlungsgehärtet wird. Dadurch kann die Trocknungszeit der Dekorveredelung erheblich verkürzt werden.

Es kann sich als praktisch erweisen, wenn das Substrat aus einem polymeren Material, insbesondere Kunststoff, gefertigt ist. Bei derartigen Substraten lässt sich das Prinzip der Erfindung besonders vorteilhaft zur Geltung bringen. Das Anbringen von farbigen Dekorierungen auf derartigen Substraten stellt sich i.d.R. anspruchsvoller dar als beispielsweise auf papierhaltigen Substraten. Aufgrund des Dekorgrunds wird die Haftung von farbigen Dekorierungen auf polymeren Substraten erheblich verbessert und die Farbauswahl für die Bebilderung des dekorierten Profilkörpers erheblich erweitert.

Es kann sich ebenfalls als vorteilhaft erweisen, wenn das Substrat ein extrudiertes Profil, bevorzugt ein Kantenbandprofil, ein Wandanschlussprofil, ein Fensterprofil oder ein Rollladenprofil, oder aber alternativ auch eine Folie, z.B. eine kalandierte Folie, ist.

Derartige Substrate bzw. Profilkörper kommen häufig in Verbindung mit anderen dekorierten Gegenständen, wie z.B. Küchenarbeitsplatten, Tischplatten, Schrankmöbel, etc., zum Einsatz, wo es im Hinblick auf ein hochwertiges optisches und ästhetisches Erscheinungsbild des Produkts auf eine möglichst genaue Abstimmung der Dekorierungen ankommt, gerade vor dem Hintergrund der bei Lichtwechsel auftretenden Metamerie-Effekte.

Durch das erfindungsgemäße Verfahren lässt sich ein dekorierter Profilkörper bereitstellen, der gerade vor diesem Hintergrund höchsten optischen und ästhetischen Ansprüchen genügt. Durch den mehrschichtigen Aufbau des Dekorgrundes in Verbindung mit der auf den Dekorgrund aufzutragenden Dekorveredelung lassen sich Farb- und Dekornuancen wesentlich detaillierter darstellen, als dies bei herkömmlichen dekorierten Profilkörpern bislang der Fall war, und das Dekor des Profilkörpers lässt sich somit besser auf ein Referenzdekor abstimmen.

Es kann sich auch als günstig erweisen, wenn zumindest eine Fondschicht einfarbig ist. Dies betrifft insbesondere die Universal-Fondschicht, die aufgetragen wird, um fertigungsbedingte Unregelmäßigkeiten des Substrats auszugleichen und um für die nachfolgende Bebilderung ein absolut neutrales Basisprodukt bereitzustellen. Diese Maßnahme erleichtert die Vorgänge der Farbmischung sowie der Einfärbung, und erlaubt es, das neutrale Basisprodukt mit hoher Präzision zu reproduzieren.

Es kann sich auch als nützlich erweisen, wenn zumindest eine Fondschicht in einem dunklen Farbton eingefärbt ist. Durch die Einfärbung des Dekorgrundes, insbesondere der Universal-Fondschicht, in einem dunklen Farbton, verringert sich der Einfärbungsaufwand und die aufzutragende Farbmenge der Individual-Fondschicht bzw. der Dekorveredelung, wenn eine Bebilderung mit einem eher dunklen Farbton erzeugt werden soll. Ein Zwischenprodukt mit Einfärbung des Dekorgrundes, insbesondere der Universal-Fondschicht, in einem dunklen Farbton, ist daher zur Bebilderung mit einem eher dunklen Farbton vorgesehen.

Es kann sich auch als nützlich erweisen, wenn zumindest eine Fondschicht in einem hellen Farbton, vorzugsweise weiß, eingefärbt ist. Durch die Einfärbung des Dekorgrundes, insbesondere der Universal-Fondschicht, in einem hellen Farbton, verringert sich der Einfärbungsaufwand und die aufzutragende Farbmenge der Individual-Fondschicht bzw. der Dekorveredelung, wenn eine Bebilderung mit einem eher hellen Farbton erzeugt werden soll.

Ein Zwischenprodukt mit Einfärbung des Dekorgrundes, insbesondere der Universal-Fondschicht, in einem hellen Farbton, ist daher zur Bebilderung mit einem eher hellen Farbton vorgesehen.

Es kann hilfreich sein, wenn zumindest eine Fondschicht, vorzugsweise die der Dekorveredelung unmittelbar benachbarte Fondschicht, in einem dem Grundfarbton der Dekorveredelung entsprechenden Farbton eingefärbt ist.

Durch die Einfärbung des Dekorgrundes, insbesondere der Individual-Fondschicht, in einem dem Grundfarbton der Dekorveredelung entsprechenden Farbton, verringert sich die aufzutragende Farbmenge der Dekorveredelung. Außerdem lassen sich Farb- und Dekornuancen dadurch besonders detailliert darstellen und auf das Referenzdekor abstimmen.

Es kann auch hilfreich sein, wenn zumindest eine Fondschicht im Digitaldruckverfahren z.B. Tintenstrahldruckverfahren aufgetragen wird. Dadurch werden die Kosten zur Durchführung des erfindungsgemäßen Verfahrens erheblich verringert.

Es kann auch praktisch sein, wenn zumindest eine Fondschicht eine Farbe auf Lösemittelbasis, eine strahlungshärtbare Farbe, vorzugsweise eine UV-härtbare Farbe, und/oder eine Farbe auf Wasserbasis enthält. Derartige Farben sind im erfindungsgemäßen Verfahren besonders vorteilhaft einsetzbar.

Es kann zudem von Vorteil sein, wenn zumindest eine Fondschicht vollflächig und/oder deckend aufgetragen wird. Dadurch vereinfacht sich der Aufbau des erfindungsgemäßen Profilkörpers. Eine Farbauswahl einer unter der deckenden Fondschicht angeordneten Schicht des Profilkörpers muss nicht nach optischen und ästhetischen Gesichtspunkten getroffen werden.

Es kann aber auch von Vorteil sein, wenn zumindest eine Fondschicht mit einer uneinheitlichen Dicke aufgetragen wird. Dadurch lassen sich räumliche Dekorierungen darstellen, was den Designspielraum gegenüber herkömmlichen Profilkörpern erheblich vergrößert. Dabei kann insbesondere der Umstand ausgenutzt werden, dass der erfindungsgemäße Profilkörper zwei Fondschichten aufweist. Die Dicke der Fondschichten beträgt vorzugsweise jeweils zwischen 1 und 500 µm.

Es kann sich als hilfreich erweisen, wenn zumindest eine Fondschicht derart aufgetragen wird, um zumindest eine Vertiefung und zumindest eine Erhebung auszubilden. Dadurch lassen sich besonders räumlich wirkende, dreidimensionale Dekorierungen darstellen, was den Designspielraum gegenüber herkömmlichen Profilkörpern noch weiter vergrößert.

Es kann sich als vorteilhaft erweisen, wenn die Dekorveredelung im Wesentlichen im Bereich mindestens einer Vertiefung einer Fondschicht aufgetragen wird. Dort findet die als Dekorveredelung aufgetragene Substanz einen besonders guten Halt und besonders ansprechende Bebilderungen mit Tiefeneffekt bzw. Tiefenwirkung sind darstellbar.

Es kann sich als praktisch erweisen, wenn die Dekorveredelung derart aufgetragen wird, um die Vertiefung im Wesentlichen auszufüllen. Dadurch wird der Auftrag der Dekorveredelung erheblich erleichtert und ein Verwischen, Verschmieren oder Verlaufen der als Dekorveredelung aufgetragenen Substanz wird verhindert.

Es kann sich als hilfreich erweisen, wenn sich die Dicke der Dekorveredelung invers zur Dicke des Dekorgrunds verhält, so dass der Dekorgrund und die Dekorveredelung mit konstanter Gesamtdicke aufgetragen werden. Dadurch kann trotz der Tiefenwirkung der Bebilderung ein dekorierter Profilkörper mit glatter Oberfläche erzeugt werden.

Es kann sich als günstig erweisen, wenn eine die Dekorveredelung zumindest abschnittsweise bedeckende Klarlackschicht aufgetragen wird. Dadurch wird die Bebilderung versiegelt und gegenüber Verschmutzung und physischer Beeinträchtigung geschützt.

Es kann sich aber auch als vorteilhaft herausstellen, wenn ein transparentes oder transluzentes Substrat bereitgestellt wird und die Dekorveredelung vor dem Dekorgrund rückseitig auf das Substrat aufgetragen wird. Dadurch kann die Profilleiste rückseitig an einem Gegenstand befestigt werden, wobei das Dekor des Profilkörpers durch das transparente oder transluzente Substrat weiterhin sichtbar ist. Im Rahmen einer spanabhebenden Nachbearbeitung der vorderseitigen Sichtkanten eines als Kantenband ausgebildeten Profilkörpers wird das Dekor nicht beeinträchtigt. Hinter dem Substrat liegend ist das Dekor auch vor anderweitigen mechanischen Einwirkungen geschützt. Vor allem aber lässt sich durch die Verlagerung des Dekors des Profilkörpers auf die Rückseite des Substrats ein räumlicher "3D"-Effekt erzielen, der das Erscheinungsbild des Profilkörpers gegenüber der vorderseitigen Dekorierung in optischer und ästhetischer Hinsicht aufwertet, und die Designfreiheit erheblich erweitert.

Bei einem Gegenstand, der zumindest eine dekorierte Oberfläche und einen dekorierten Profilkörper, hergestellt gemäß dem Verfahren nach einem der vorangegangenen Ausführungen, umfasst, weist der Gegenstand das Referenzdekor auf, auf welches das Dekor des Profilkörpers derart abgestimmt ist, so dass im Wesentlichen kein Metamerie-Effekt auftritt. Vorzugsweise ist dazu zumindest eine Fondschicht des Profilkörpers in einem dem Grundfarbton der dekorierten Oberfläche entsprechenden Farbton eingefärbt. Bei dem Gegenstand kann es sich beispielsweise um ein insbesondere plattenförmiges Möbelelement handeln, an dessen Kante(n) der Profilkörper z.B. mittels eines Haftvermittlers angeklebt ist.

Dieser Gegenstand ist in optischer und ästhetischer Hinsicht besonders hochwertig, da Farbabweichungen und Metamerie-Effekte zwischen dem Referenzdekor und dem Dekor des Profilkörpers ausgeschaltet werden, weil das Referenzdekor und das Dekor des Profilkörpers auch bei Lichtwechsel in ähnliche Farbtöne umschlagen.

### Kurze Beschreibung der Zeichnungen:

- Fig. 1: zeigt eine Schnittansicht des erfindungsgemäß hergestellten dekorierten Profilkör- pers in einem zum Zweck der besseren Darstellung verzerrten Maßstab.
- Fig. 2: zeigt eine perspektivische Ansicht des erfindungsgemäß hergestellten dekorierten Profilkörpers in einem zum Zweck der besseren Darstellung verzerrten Maßstab.
- Fig. 3: zeigt den erfindungsgemäß hergestellten dekorierten Profilkörper gemäß Fig. 1 und 2 in einem montierten Zustand an einem Gegenstand mit dekorierter Oberfläche.
- Fig. 4: zeigt einen erfindungsgemäß hergestellten dekorierten Profilkörper mit vollflächig aufgetragenem Dekorgrund und vollflächig aufgetragener Dekorveredelung in ei- nem montierten Zustand an einem Gegenstand mit dekorierter Oberfläche.
- Fig. 5: zeigt einen erfindungsgemäß hergestellten dekorierten Profilkörper mit vollflächig aufgetragenem Dekorgrund und vollflächig aufgetragener Dekorveredelung in ei- nem montierten Zustand an einem Gegenstand mit dekorierter Oberfläche, wobei das Substrat transparent ist und der Dekorgrund und die Dekorveredelung an der Substratunterseite angeordnet sind.

### Detaillierte Beschreibung der bevorzugten Ausführungsbeispiele:

Die Erfindung betrifft ein Verfahren zum Herstellen eines dekorierten Profilkörpers 1, umfassend die Schritte: a) Bereitstellen eines Substrats 2; b) Auftragen eines Dekorgrundes 4, 5; und c) Auftragen einer den Dekorgrund 4, 5 zumindest abschnittsweise bedeckenden Dekorveredelung 6 im Digitaldruckverfahren, wobei der Dekorgrund 4, 5 und die Dekorveredelung 6 zusammen ein Dekor des Profilkörpers 1 bilden. Der Dekorgrund 4, 5 weist einen Farbaufbau aus einem gegenüber der Dekorveredelung 6 erweiterten Farbraum auf, wobei der Farbaufbau des Dekorgrundes 4, 5 derart ausgewählt ist, dass zwischen dem Dekor des Profilkörpers 1 und einem dazu ähnlichen, vorzugsweise identischen Referenzdekor im Wesentlichen kein Metamerie-Effekt auftritt. Das Referenzdekor ist vorzugsweise das Dekor einer dekorierten Oberfläche 9 eines Gegenstands 8.

Der Dekorgrund 4, 5 enthält zwei voneinander unterschiedlich eingefärbte Fondschichten 4, 5, die als Universal-Fondschicht 4 und Individual-Fondschicht 5 bezeichnet werden. Im Rahmen der Erfindung liegt es aber auch, dass der Dekorgrund nur aus der Individual-Fondschicht 5 besteht.

Der erfindungsgemäß hergestellte, dekorierte Profilkörper 1 wird nachstehend anhand der beiliegenden Zeichnungen erläutert:

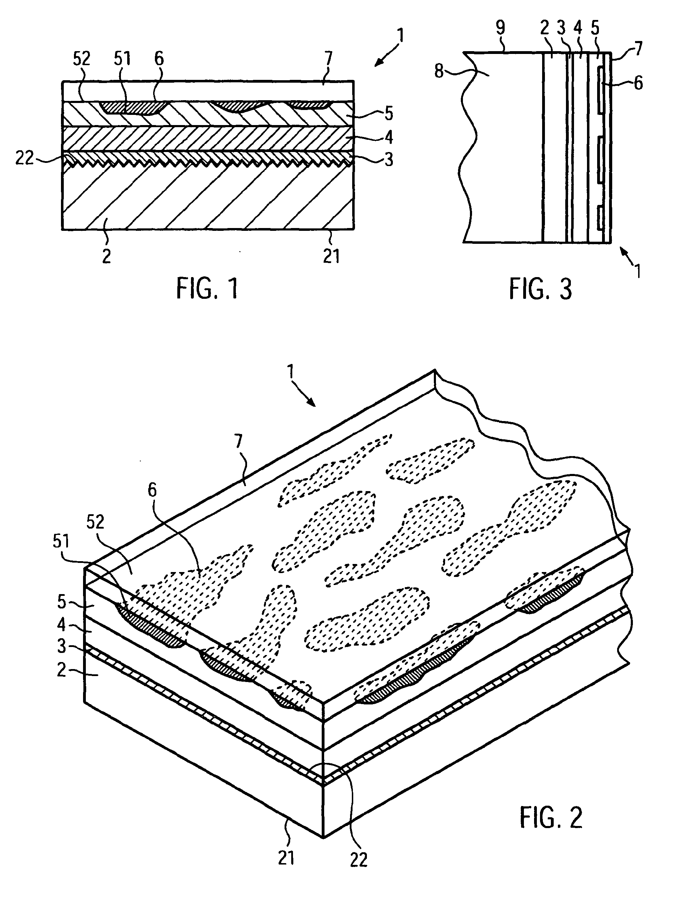

Fig. 1 zeigt eine Schnittansicht des erfindungsgemäß hergestellten, dekorierten Profilkörpers 1 in einem zum Zweck der besseren Darstellung verzerrten Maßstab.

Der dekorierte Profilkörper 1 umfasst ein Substrat 2 mit einer Unterseite 21 und einer Oberseite 22, optional eine Primerschicht 3 zur Verbesserung der Haftung nachfolgender Schichten auf dem Substrat 2, eine Universal-Fondschicht 4, eine Individual-Fondschicht 5 mit Vertiefungen 51 und Erhebungen 52, eine Dekorveredelung 6, welche vorzugsweise die Vertiefungen 51 der Individual-Fondschicht 5 ausfüllt, und eine vollflächig aufgetragene Klarlackschicht 7. In den Darstellungen der Fig. 1 bis 3 ist der dekorierte Profilkörper 1 ein Kantenband. Mit der Unterseite 21 wird der dekorierte Profilkörper 1 an einem Gegenstand 8, z.B. einer Küchenarbeitsplatte oder einer Tischplatte befestigt. Zur Verbesserung des optischen Erscheinungsbilds des dekorierten Profilkörpers 1 verhält sich die Dicke der Individual-Fondschicht 5 invers zu der Dicke der Dekorveredelung 6, so dass die Gesamtdicke (Summe der Dicken) der Individual-Fondschicht 5 und der Dekorveredelung 6 jeweils konstant bleibt. Primerschicht 3 und Universal-Fondschicht 4 können auch zu einer Schicht zusammengefasst sein, die beide Funktionen der Schichten 3 und 4 abdeckt.

Fig. 2 zeigt eine perspektivische Ansicht des erfindungsgemäß hergestellten dekorierten Profilkörpers 1 in einem zum Zweck der besseren Darstellung verzerrten Maßstab. Auf der Oberseite des Profilkörpers 1 ist durch die Klarlackschicht 7 das Dekor des Profilkörpers 1 sichtbar. Das Dekor des Profilkörpers 1 stellt z.B. eine Holzmaserung oder Marmorierung dar, unterliegt jedoch keiner Beschränkung. Als Klarlackschicht 7 wird ein transparenter oder transluzenter Lack aufgetragen, der vorzugsweise durch Beaufschlagung mit UV-Strahlung härtbar ist. Bei Einfärbung des Klarlacks kann die Klarlackschicht 7 einen Teil des sichtbaren Dekors des Profilkörpers 1 bilden.

Fig. 3 zeigt den erfindungsgemäß hergestellten dekorierten Profilkörper 1 gemäß Fig. 1 in einem montiertem Zustand an einem Gegenstand 8 mit dekorierter Oberfläche 9. Die dekorierte Oberfläche 9 des Gegenstands 8 weist ein Referenzdekor auf. Das Dekor des Profilkörpers 1 ist auf das Referenzdekor abgestimmt bzw. ist ähnlich oder identisch zu dem Referenzdekor, oder weist zumindest ein ähnliches oder identisches Motiv auf. Die Individual-Fondschicht 5 ist in einem dem Grundfarbton der dekorierten Oberfläche 9 entsprechenden und auf die Dekorveredelung 6 abgestimmten Farbton eingefärbt. Die farbliche Abstimmung der Individual-Fondschicht 5, der Dekorveredelung 6 und der dekorierten Oberfläche 9 erfolgt mittels eines Softwareprogramms, so dass zwischen dem Dekor des Profilkörpers 1 und dem Referenzdekor kein, bzw. nur ein geringer, Metamerie-Effekt auftritt.

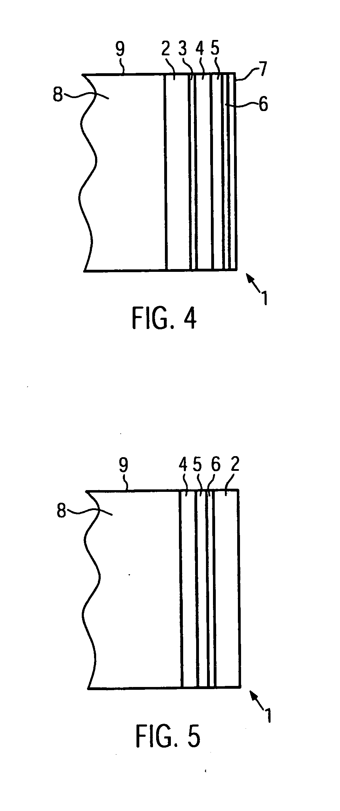

Fig. 4 zeigt einen erfindungsgemäß hergestellten dekorierten Profilkörper 1 mit vollflächig aufgetragenem Dekorgrund 4, 5 und vollflächig aufgetragener Dekorveredelung 6 in einem montierten Zustand an dem Gegenstand 8 mit dekorierter Oberfläche 9 aus Fig. 3. Der Schichtaufbau des Profilkörpers 1 aus Fig. 4 entspricht im Wesentlichen dem Schichtaufbau des Profilkörpers 1 aus Fig. 3, mit der Ausnahme, dass der Dekorgrund 4, 5 und die Dekorveredelung 6 vollflächig aufgetragen sind.

Fig. 5 zeigt einen erfindungsgemäß hergestellten dekorierten Profilkörper 1 mit vollflächig aufgetragenem Dekorgrund 4, 5 und vollflächig aufgetragener Dekorveredelung 6 in einem montierten Zustand an dem Gegenstand 8 mit dekorierter Oberfläche 9 aus Fig. 3, wobei das Substrat 2 transparent ist und der Dekorgrund 4, 5 und die Dekorveredelung 6 rückseitig auf das Substrat 2 aufgetragen sind. Das Dekor des Profilkörpers 1 ist auf das Referenzdekor der dekorierten Oberfläche 9 des Gegenstands 8 abgestimmt.

Die in den Fig. 1 bis 5 dargestellten Profilkörper 1 können in bekannter Weise mittels eines nicht näher dargestellten Haftvermittlers an dem Gegenstand 8, z.B. einer Möbelplatte, befestigt sein. Während bei den in Fig. 1 bis 4 dargestellten Ausführungen der Haftvermittler zwischen dem Gegenstand 8 und dem Substrat 2 angeordnet ist, befindet er sich beim Beispiel gemäß Fig. 5 zwischen dem Dekorgrund 4 und dem Gegenstand 8. In diesem Fall kann es zweckmäßig sein, den Haftvermittler einzufärben, um z.B. die Farbdeckkraft des gesamten Aufbaus zu erhöhen.

Die Individual-Fondschicht 5 ist in einem dem Grundfarbton der dekorierten Oberfläche 9 entsprechenden und auf die Dekorveredelung 6 abgestimmten Farbton eingefärbt. Die farbliche Abstimmung der Individual-Fondschicht 5, der Dekorveredelung 6 und der dekorierten Oberfläche 9 erfolgt mittels eines Softwareprogramms, so dass zwischen dem Dekor des Profilkörpers 1 und dem Referenzdekor kein, bzw. nur ein geringer, Metamerie-Effekt auftritt.

Im Ergebnis zeichnet sich die Erfindung dadurch aus, dass mittels des beschriebenen Verfahrens Metamerie-Effekte bei digitaler Bedruckung vermieden werden können. Charakteristisch ist insbesondere, dass, wenn die Dekorveredelung 6 transluzente Farben enthält, die Individual-Fondschicht auch dort einen Einfluss auf das Erscheinungsbild des fertig erzeugten dekorierten Profilkörpers 1 hat, wo die Dekorveredelung 6 aufgetragen ist. Die erforderliche "unendliche Anzahl" von Farbtönen (Sonderfarbraum) bei der Individual-Fondschicht 5 ist entweder durch einen konventionellen Druck, oder aber auch durch digitale Bedruckung, z.B. mittels eines Ink-Jet-Verfahrens, realisierbar.

Nachfolgend werden die Schritte des erfindungsgemäßen Verfahrens im Einzelnen erläutert:
Schritt a): Mit einem Extrusionswerkzeug wird ein extrudierter Profilkörper bereitgestellt, der als Substrat 2 im Sinne der Erfindung bezeichnet wird. Alternativ kann auch ein kalandrierter Profilkörper, z.B. eine Folie, verwendet werden. Das Substrat 2 wird vorzugsweise als Kantenbandprofil, Wandanschlussprofil, Fensterprofil, Rollladenprofil, Folie, z.B. kalandriert, oder dergleichen bereitgestellt. Der Begriff bzw. Wortstamm "bereitstellen" ist in diesem Zusammenhang so zu verstehen, dass das Substrat 2 entweder unmittelbar vor der Weiterverarbeitung hergestellt oder bereits in einem vorgefertigten Zustand den nachfolgenden Schritten der Weiterverarbeitung zugeführt wird. Das Substrat 2 wird aus einem polymeren Werkstoff, insbesondere Kunststoff, vorzugsweise Polypropylen (PP), Polyvinylchlorid (PVC), Acrylnitril-Butadien-Styrol (ABS), Polymethylmethacrylat (PMMA) oder Polyethylenterephthalat (PET) gefertigt. Dazu wird der als Granulat vorliegende Werkstoff in der Extrusionseinrichtung aufgeschmolzen und durch die Extrusionseinrichtung in eine bestimmungsgemäße Querschnittsform überführt, wobei die gewünschte Querschnittsform des Substrats 2 in einer nachgeschalteten Kalibriereinrichtung kalibriert und fixiert wird.
   In einem nachfolgenden Schritt wird die der Substratunterseite 21 gegenüber liegende Substratoberseite 22, vorzugsweise - insbesondere bei polyolefinen Werkstoffen - physikalisch behandelt, beispielsweise durch Coronabehandlung, um die Oberflächenenergie zu erhöhen und die Oberfläche 22 aufzurauen, um die Haftung nachfolgender Schichten zu verbessern.
   Optional, insbesondere bei Substraten 2 aus dem Werkstoff Polypropylen, wird eine Primerschicht 3 auf die vorzugsweise vorbehandelte Oberfläche 22 aufgetragen, um die Haftung nachfolgender Schichten noch weiter zu verbessern.
Schritt b): In einer Universal-Fondschicht-Aufbringungseinrichtung wird nachfolgend eine Universal-Fondschicht 4 aufgetragen. Die Universal-Fondschicht 4 ist eine neutrale Farbschicht zum Ausgleich fertigungsbedingter Unregelmäßigkeiten, wie z.B. Farbnuancen oder Unebenheiten etc. des Substrats 2, und wird vollflächig auf das Substrat 2 bzw. auf die Primerschicht 3 aufgetragen. Der Auftrag erfolgt konventionell mittels Druckwalzen oder im Digitaldruckverfahren, vorzugsweise über eine spezielle Tintenstrahtdruckvorrichtung. Die für die Universal-Fondschicht 4 zum Einsatz kommenden Farbsysteme sind Farben auf Lösemittelbasis, UV-härtende Farben und Farben auf Wasserbasis.
   Die Universal-Fondschicht 4 ist opak, d.h. sie deckt die darunter liegende Schicht (das Substrat 2 oder die Primerschicht 3) vorzugsweise vollflächig, ab. Die Universal-Fondschicht 4 ist in einem hellen oder dunklen Farbton eingefärbt, um eine grundlegende Sortierung für die Weiterverarbeitung vornehmen zu können. Ein Substrat 2 mit Universal-Fondschicht 4 in einem hellen Farbton (z.B. weiß) ist für eine Bebilderung mit hellem Grundfarbton vorgesehen, und ein Substrat 2 mit Universal-Fondschicht 4 in einem dunklen Farbton ist für eine Bebilderung mit einem dunklen Grundfarbton vorgesehen. Dieses so gefertigte Vorprodukt wird anschließend im Lager abgelegt und zur Endfertigung bereit gehalten.
   Bei der Endfertigung wird die Individual-Fondschicht 5 auf die Universal-Fondschicht 4 aufgebracht. Die Universal-Fondschicht 4 ist so gewählt, dass möglichst wenig zusätzliche Einfärbung durch die Individual-Fondschicht 5 erforderlich ist. Generell ist es möglich, beispielsweise im Extremfall lediglich mittels einiger Universal-Fondschicht-Farben zu arbeiten. Die Individual-Fondschicht 5 ist opak, d.h. sie deckt die darunter liegende Universal-Fondschicht 4, vorzugsweise vollflächig, ab, und ist in einem Farbton eingefärbt, der dem Grundfarbton einer Dekorvorlage wie einer dekorierten Oberfläche 9 eines Gegenstands 8 (z.B. Tischplatte oder Küchenarbeitspatte; Fig. 3) und dem Grundfarbton der Dekorveredelung 6 entspricht.
   Die Individual-Fondschicht 5 kann konventionell mittels Druckwalzen oder ebenfalls im Digitaldruckverfahren, z.B. über eine spezielle Tintenstrahldruckvorrichtung mit erweitertem Farbraum (Sonderfarbraum) aufgetragen werden. Die möglichen Farbsysteme, die für die Individual-Fondschicht 5 zum Einsatz kommen können, sind ausgewählt aus den Farben auf Lösemittelbasis, UV-härtenden Farben und Farben auf Wasserbasis.
Schritt c): In einem nachfolgenden Schritt wird die Dekorveredelung 6 mit einer Tintenstrahldruckvorrichtung im Tintenstrahldruckverfahren (Inkjet-Verfahren) aufgetragen. Die Dekorveredelung 6 weist einen Farbaufbau aus dem CMYK-Farbraum auf, d.h. eine Kombination der Farben Cyan, Magenta und Yellow und Schwarz (Key). Die Dekorveredelung 6 ist in der Regel lasierend und nicht vollständig deckend, und wird daher als transparente oder transluzente Substanz aufgetragen.

Durch gezielte Pigmentauswahl und Mischung der Farbe der Individual-Fondschicht 5 wird das Umschlagen der Farbe des Dekors des Profilkörpers 1 bei Lichtartwechsel im Sinne des Referenzdekors begünstigt, so dass im Wesentlichen kein Metamerie-Effekt auftritt.

Eine vollflächige Individual-Fondschicht 5 hat zudem den Vorteil, dass sich die Druckpunktausbildung sowie die Haftung der Dekorveredelung 6 erheblich verbessert. Die Dekorveredelung 6 wird vorzugsweise nur abschnittweise auf die Individual-Fondschicht 5 aufgetragen, bevorzugt nur in den Bereichen der Vertiefungen 51, um diese Vertiefungen 51 aufzufüllen sowie auszufüllen. Dabei verhält sich die Dicke der Dekorveredelung 6 invers zu der Dicke der Individual-Fondschicht 5, so dass die Gesamtdicke (Summe der Dicken) der Individual-Fondschicht 5 und der Dekorveredelung 6 jeweils konstant bleibt. Die als Dekorveredelung 6 aufgetragene Substanz ist vorzugsweise strahlungshärtbar, bevorzugt UVhärtbar, und wird durch Beaufschlagung mit einer Strahlungsquelle gehärtet. Optional wird zusätzlich eine Klarlackschicht 7 aufgetragen, um das Dekor des Profilkörpers 1 zu versiegeln und zu schützen.

Durch die individuell gemischte Sonderfarbe der Individual-Fondschicht 5 in Kombination mit der aus dem CMYK-Farbraum ausgewählten Farbe der Dekorveredelung 6 kann der Farbraum des Dekors des Profilkörpers 1 (bestehend aus dem Dekorgrund 4, 5 bzw. Universal-Fondschicht 4 und Individual-Fondschicht 5 sowie der Dekorveredelung 6) um den gegebenen Farbraum der reinen Skalenfarben erweitert werden. Die Individual-Fondschicht 5 ist in den Bild- bzw. Farbaufbau des Dekors des Profilkörpers 1 integriert und wird bei der Farbgebung mit berücksichtigt.

Das Prinzip der Erfindung ist für ein beliebiges Substrat 2 anwendbar und insbesondere geeignet für polymere Substrate 2 wie extrudierte Kunststoffprofile, insbesondere Kantenbandprofile, Wandanschlussprofile, Fensterprofile und Rollladenprofile aber auch beispielsweise Folien, z.B. kalandrierte Folien, insbesondere Folien mit einer Schichtdicke >= 0,05 mm, vorzugsweise 0,2 bis 0,4 mm Schichtdicke.

### Bezugszeichenliste

- 1: Profilkörper
- 2: Substrat
- 3: Primerschicht
- 4: Universal- Fondschicht
- 5: Individual-Fondschicht
- 6: Dekorveredelung
- 7: Klarlackschicht
- 8: Gegenstand
- 9: Dekorierte Oberfläche
- 21: Substrat-Unterseite
- 22: Substrat-Oberseite
- 51: Vertiefungen
- 52: Erhebungen

## Patentansprüche

1. Verfahren zum Herstellen eines dekorierten Profilkörpers (1), umfassend die Schritte: Bereitstellen eines Substrats (2); Auftragen eines Dekorgrundes (4,5); und Auftragen einer den Dekorgrund (4,5) zumindest abschnittsweise bedeckenden Dekorveredelung (6) im Digitaldruckverfahren, wobei der Dekorgrund (4,5) und die Dekorveredelung (6) zusammen ein Dekor des Profilkörpers (1) bilden, **dadurch gekennzeichnet, dass** der Dekorgrund (4,5) einen Farbaufbau aus einem gegenüber der Dekorveredelung (6) erweiterten Farbraum aufweist, wobei der Farbaufbau des Dekorgrundes (4,5) derart ausgewählt ist, dass zwischen dem Dekor des Profilkörpers (1) und einem dazu ähnlichen, vorzugsweise identischen Referenzdekor im Wesentlichen kein Metamerie-Effekt auftritt.

2. Verfahren nach Anspruch 1, **dadurch gekennzeichnet, dass** der Dekorgrund (4,5) voneinander unterschiedlich eingefärbte Fondschichten (4,5) enthält.

3. Verfahren nach einem der vorangegangenen Ansprüche, **dadurch gekennzeichnet, dass** als Dekorveredelung (6) zumindest abschnittsweise eine transluzente oder transparente Substanz aufgetragen wird.

4. Verfahren nach einem der vorangegangenen Ansprüche, **dadurch gekennzeichnet, dass** die Dekorveredelung (6) strahlungsgehärtet wird.

5. Verfahren nach einem der vorangegangenen Ansprüche, **dadurch gekennzeichnet**, das die Dekorveredelung (6) einen aus dem CMYK-Farbraum ausgewählten Farbaufbau aufweist.

6. Verfahren nach einem der vorangegangenen Ansprüche, **dadurch gekennzeichnet, dass** das Substrat (2) aus einem polymeren Material gefertigt ist.

7. Verfahren nach einem der vorangegangenen Ansprüche, **dadurch gekennzeichnet, dass** das Substrat (2) ein extrudiertes oder kalandriertes Profil, bevorzugt ein Kantenbandprofil, ein Wandanschlussprofil, ein Fensterprofil oder ein Rollladenprofil, oder eine Folie ist.

8. Verfahren nach einem der vorangegangenen Ansprüche, **dadurch gekennzeichnet, dass** zumindest eine Fondschicht (4,5), vorzugsweise die der Dekorveredelung (6) unmittelbar benachbarte Fondschicht (5), in einem dem Grundfarbton des Referenzdekors entsprechenden Farbton eingefärbt ist.

9. Verfahren nach einem der vorangegangenen Ansprüche, **dadurch gekennzeichnet, dass** zumindest eine Fondschicht (4,5) eine Farbe auf Lösemittelbasis, eine strahlungshärtbare Farbe, vorzugsweise eine UV-härtbare Farbe, und/oder eine Farbe auf Wasserbasis enthält.

10. Verfahren nach einem der vorangegangenen Ansprüche, **dadurch gekennzeichnet, dass** zumindest eine Fondschicht (4,5) derart aufgetragen wird, so dass zumindest eine Vertiefung (51) und zumindest eine Erhebung (52) ausgebildet wird.

11. Verfahren nach einem der vorangegangenen Ansprüche, **dadurch gekennzeichnet, dass** die Dekorveredelung (6) im Wesentlichen im Bereich mindestens einer Vertiefung (51) einer Fondschicht (5) aufgetragen wird.

12. Verfahren nach einem der vorangegangenen Ansprüche, **dadurch gekennzeichnet, dass** die Dekorveredelung (6) derart aufgetragen wird, um die Vertiefung (51) im Wesentlichen auszufüllen.

13. Verfahren nach einem der vorangegangenen Ansprüche, **dadurch gekennzeichnet, dass** sich die Dicke der Dekorveredelung (6) invers zur Dicke des Dekorgrunds (4,5) verhält, so dass der Dekorgrund (4,5) und die Dekorveredelung (6) mit konstanter Gesamtdicke aufgetragen werden.

## Claims

1. Method for producing a decorated profile body (1), comprising the steps: providing a substrate (2); applying a decorative base (4, 5); and applying a decorative finish (6) covering at least some sections of the decorative base (4, 5) in the digital printing process, the decorative base (4, 5) and the decorative finish (6) together forming a decoration of the profile body (1), **characterized in that** the decorative base (4, 5) has a colour structure from a colour space expanded with respect to the decorative finish (6), the colour structure of the decorative base (4, 5) being chosen in such a way that substantially no metameric effect occurs between the decoration of the profile body (1) and a reference decoration that is similar thereto, preferably identical.

2. Method according to Claim 1, **characterized in that** the decorative base (4, 5) contains foundation layers (4, 5) that are dyed differently from one another.

3. Method according to one of the preceding claims, **characterized in that** the decorative finish (6) applied, at least in some sections, is a translucent or transparent substance.

4. Method according to one of the preceding claims, **characterized in that** the decorative finish (6) is radiation-cured.

5. Method according to one of the preceding claims, **characterized in that** the decorative finish (6) has a colour structure selected from the CMYK colour space.

6. Method according to one of the preceding claims, **characterized in that** the substrate (2) is made of a polymer material.

7. Method according to one of the preceding claims, **characterized in that** the substrate (2) is an extruded or calendered profile, preferably an edge-strip profile, a wall connection profile, a window profile or a roller shutter profile, or a film.

8. Method according to one of the preceding claims, **characterized in that** at least one foundation layer (4, 5), preferably the foundation layer (5) immediately adjacent to the decorative finish (6), is dyed in a colour corresponding to the basic colour of the reference decoration.

9. Method according to one of the preceding claims, **characterized in that** at least one foundation layer (4, 5) contains a solvent-based colour, a radiation-curable colour, preferably a UV-curable colour, and/or a water-based colour.

10. Method according to one of the preceding claims, **characterized in that** at least one foundation layer (4, 5) is applied in such a way that at least one depression (51) and at least one elevation (52) are formed.

11. Method according to one of the preceding claims, **characterized in that** the decorative finish (6) is applied substantially in the region of at least one depression (51) of a foundation layer (5).

12. Method according to one of the preceding claims, **characterized in that** the decorative finish (6) is applied in such a way as to substantially fill the depression (51).

13. Method according to one of the preceding claims, **characterized in that** the thickness of the decorative finish (6) behaves inversely with respect to the thickness of the decorative base (4, 5), so that the decorative base (4, 5) and the decorative finish (6) are applied with a constant total thickness.

## Revendications

1. Procédé de fabrication d'un corps profilé décoré (1), comprenant les étapes suivantes: préparer un substrat (2); déposer un fond de décor (4, 5), et déposer un motif décoratif (6) recouvrant au moins en partie le fond de décor (4, 5) par un procédé d'impression numérique, dans lequel le fond de décor (4, 5) et le motif décoratif (6) forment ensemble un décor du corps profilé (1), **caractérisé en ce que** le fond de décor (4, 5) présente une structure de couleurs composée d'une palette de couleurs élargie par rapport au motif décoratif (6), dans lequel la structure de couleurs du fond de décor (4, 5) est choisie de telle manière qu'il n'existe essentiellement aucun effet de métamérisme entre le décor du corps profilé (1) et un décor de référence similaire, de préférence identique à celui-ci.

2. Procédé selon la revendication 1, **caractérisé en ce que** le fond de décor (4, 5) contient des couches de fond (4, 5) colorées différemment l'une de l'autre.

3. Procédé selon l'une quelconque des revendications précédentes, **caractérisé en ce que** l'on dépose au moins en partie comme motif décoratif (6) une substance translucide ou transparente.

4. Procédé selon l'une quelconque des revendications précédentes, **caractérisé en ce que** l'on durcit le motif décoratif (6) par rayonnement.

5. Procédé selon l'une quelconque des revendications précédentes, **caractérisé en ce que** le motif décoratif (6) présente une structure de couleurs choisie dans la palette de couleurs CMJN.

6. Procédé selon l'une quelconque des revendications précédentes, **caractérisé en ce que** le substrat (2) est fabriqué en un matériau polymère.

7. Procédé selon l'une quelconque des revendications précédentes, **caractérisé en ce que** le substrat (2) est un profilé extrudé ou calandré, de préférence un profilé d'alaise de chant, un profilé de raccord mural, un profilé pour châssis de fenêtre ou un profilé pour volet roulant.

8. Procédé selon l'une quelconque des revendications précédentes, **caractérisé en ce qu'**au moins une couche de fond (4, 5), de préférence la couche de fond (5) immédiatement adjacente au motif décoratif (6), est colorée dans une nuance de couleur correspondant à la nuance de couleur de fond du décor de référence.

9. Procédé selon l'une quelconque des revendications précédentes, **caractérisé en ce qu'**au moins une couche de fond (4, 5) contient une couleur à base de solvant, une couleur durcissant par rayonnement, de préférence une couleur durcissant aux UV, et/ou une couleur à base d'eau.

10. Procédé selon l'une quelconque des revendications précédentes, **caractérisé en ce que** l'on dépose au moins une couche de fond (4, 5) de telle manière qu'il se forme au moins un creux (51) et au moins une surélévation (52).

11. Procédé selon l'une quelconque des revendications précédentes, **caractérisé en ce que** l'on dépose le motif décoratif (6) essentiellement dans la région d'au moins un creux (51) d'une couche de fond (5).

12. Procédé selon l'une quelconque des revendications précédentes, **caractérisé en ce que** l'on dépose le motif décoratif (6) de façon à remplir essentiellement le creux (51).

13. Procédé selon l'une quelconque des revendications précédentes, **caractérisé en ce que** l'épaisseur du motif décoratif (6) évolue à l'inverse de l'épaisseur du décor de fond (4, 5), de telle manière que le décor de fond (4, 5) et le motif décoratif (6) soient déposés avec une épaisseur totale constante.
